(19) Europäisches Patentamt / European Patent Office / Office européen des brevets

(11) **EP 4 042 197 B1**

(12) **FASCICULE DE BREVET EUROPEEN**

(45) Date de publication et mention
de la délivrance du brevet:
**04.03.2026 Bulletin 2026/10**

(21) Numéro de dépôt: **20781021.9**

(22) Date de dépôt: **02.10.2020**

(51) Classification Internationale des Brevets (IPC):
***G01S 13/72*** *(2006.01)*   ***G01S 7/295*** *(2006.01)*
***H03H 17/02*** *(2006.01)*

(52) Classification Coopérative des Brevets (CPC):
**G01S 13/72; G01S 7/295; H03H 17/0257**

(86) Numéro de dépôt international:
**PCT/EP2020/077702**

(87) Numéro de publication internationale:
**WO 2021/069329 (15.04.2021 Gazette 2021/15)**

(54) **PROCÉDÉ ET DISPOSITIF D'ESTIMATION DE L'ÉTAT D'UNE CIBLE MANOEUVRANTE PAR UN RADAR MOBILE**

VERFAHREN UND VORRICHTUNG ZUR ZUSTANDSSCHÄTZUNG EINES MANÖVERZIELS DURCH EIN MOBILES RADAR

METHOD AND DEVICE FOR ESTIMATING THE STATUS OF A MANEUVERING TARGET BY A MOBILE RADAR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.10.2019 FR 1911227**

(43) Date de publication de la demande:
**17.08.2022 Bulletin 2022/33**

(73) Titulaire: **THALES**
**92190 Meudon (FR)**

(72) Inventeur: **ATTAL, Yoann**
**78990 Elancourt (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**EP-A1- 3 514 571**      **FR-A1- 2 763 147**
**US-A1- 2017 097 410**

• **MARION PILTÉ ET AL: "Invariant Extended Kalman Filter for Target Tracking / Filtre de Kalman Etendu Invariant pour Pistage de Cibles", GÉOLOCALISATION ET NAVIGATION DANS L'ESPACE ET LE TEMPS, U.R.S.I FRANCE JS18, 28 March 2018 (2018-03-28), XP055707764**
• **HUAI TIANYI ET AL: "Active Sensor Radiation Control Based on Posterior Cramer-Rao Lower Bound with Passive Measurement", 2019 CHINESE CONTROL CONFERENCE (CCC), TECHNICAL COMMITTEE ON CONTROL THEORY, CHINESE ASSOCIATION OF AUTOMATION, 27 July 2019 (2019-07-27), pages 3564 - 3570, XP033635459, DOI: 10.23919/ CHICC.2019.8866514**

EP 4 042 197 B1

## Description

### Art antérieur

L'invention se rapporte généralement au domaine des systèmes de surveillance et en particulier à un procédé et à un dispositif d'estimation implémenté dans un radar mobile.

L'utilisation des radars a connu un essor majeur ces dernières années dans divers domaines tels que l'aéronautique, l'automobile et la métrologie. Les radars constituent un outil efficace non seulement pour détecter la présence d'une cible distante mais aussi pour suivre l'évolution de son état au cours du temps à travers un processus d'estimation. Un tel état de la cible peut être représenté par un ensemble de paramètres d'état comprenant classiquement la position, la vitesse de déplacement et l'accélération.

Les radars existants peuvent être classés selon plusieurs critères tels que la mobilité, la bande de fréquence des signaux manipulés, le mode de fonctionnement, etc. Un radar peut fonctionner dans un mode actif dans lequel le radar émet des signaux et analyse la partie rétrodiffusée par la cible considérée, ou dans un mode passif dans lequel le rôle du radar se limite à analyser les signaux pouvant être émis par la cible.

Pour réaliser l'estimation de l'état d'une cible distante en utilisant un radar opérant dans un mode actif ou passif, il est connu d'élaborer d'abord un modèle dynamique aussi précis que possible modélisant l'évolution de l'état de la cible au cours du temps à travers une équation mathématique dite équation d'état. Un algorithme de filtrage est ensuite appliqué en utilisant l'équation d'état élaborée et en tenant compte des mesures expérimentales effectuées par le radar pour estimer l'état de la cible. Un tel algorithme de filtrage est souvent implémenté d'une manière récursive pour exécuter deux étapes à chaque iteration : une étape de prédiction suivie d'une étape de correction appelée aussi étape de mise à jour. La première étape consiste à résoudre l'équation d'état pour fournir un état dit a priori. La deuxième étape de l'algorithme de filtrage est déclenchée après la réception d'une mesure de l'état de la cible et permet d'ajuster l'état de la cible a priori telle que déjà prédit avec la mesure effectuée pour retourner un état de la cible dit a posteriori. L'algorithme de filtrage peut associer une matrice de covariance à l'état de la cible a posteriori pour refléter le degré de fiabilité de l'état a posteriori de la cible estimé.

L'état de la cible à suivre peut évoluer selon un modèle dynamique linéaire. Dans un système à temps discret, un modèle dynamique linéaire implique que chaque paramètre d'état de la cible à un instant donné k peut être exprimé par une équation comprenant une combinaison linéaire des paramètres d'état de la cible à l'instant antérieur (k-1). De la même manière, une mesure de l'état de la cible à un instant donné k peut comprendre une combinaison linéaire des paramètres d'état de la cible par rapport au même instant k. Chaque paramètre d'état de la cible calculé ou mesuré peut être affecté par un bruit qui peut être blanc additif gaussien dont les paramètres peuvent être différents d'un paramètre d'état de la cible à un autre et d'un instant de mesure à un autre. Un modèle dynamique linéaire permet en outre de préserver la loi régissant le bruit qui affecte les paramètres d'état de la cible en passant d'un instant de traitement à un autre. Des filtres adaptés pour suivre l'évolution linéaire d'une cible ont été proposés et implémentés, tels que le filtre de Kalman linéaire. Un filtre de Kalman linéaire calcule à l'étape de prédiction de chaque itération l'état a priori de la cible en résolvant l'équation d'état fourni par le modèle et associe à l'état a priori calculé une matrice de covariance dite matrice de covariance a priori. Les sorties de l'étape de prédiction sont utilisées à l'étape de correction pour calculer un gain du filtre de Kalman qui servira ensuite pour pondérer les contributions de l'état a priori de la cible et de la mesure lors du calcul de l'état a posteriori de la cible. Une matrice de covariance de l'erreur, dite matrice de covariance de l'erreur a posteriori, est calculée et est associée à l'état a posteriori de la cible. Les sorties de l'étape de correction sont utilisées ensuite comme entrées lors de l'itération suivante du filtre de Kalman linéaire.

Les cibles actuelles sont de plus en plus manœuvrantes de sorte qu'un modèle d'évolution linéaire est souvent incapable de régir l'évolution de leur état. Dans un modèle d'évolution non-linéaire, chaque paramètre d'état de la cible calculé à un instant k peut comprendre une combinaison non linéaire des paramètres d'état de la cible à l'instant antérieur (k-1). De la même manière, chaque paramètre d'état de la cible mesuré à un instant donné k peut comprendre une combinaison non linéaire des paramètres d'état de la cible par rapport au même instant k. Une fonction non linéaire d'état permettant de lier deux états consécutifs d'une cible et une fonction de mesure également non linéaire liant l'état de la cible à la mesure effectuée peuvent être définies. La complexité d'un modèle d'évolution non-linéaire réside essentiellement dans le fait que la loi régissant le bruit qui affecte les paramètres d'état de la cible, à un instant (k-1) donné, peut ne pas être la même à l'instant postérieur k. Par exemple, une variable aléatoire qui suit une loi de probabilité gaussienne peut perdre sa loi de probabilité en subissant une transformation non linéaire. Le filtre de Kalman étendu, encore appelé EKF (Extended Kalman Filter), a été proposé pour estimer l'état d'une cible évoluant selon un modèle non-linéaire en linéarisant à chaque itération la fonction d'état régissant l'évolution de l'état de la cible autour de la moyenne de l'état estimé en utilisant les dérivés partielles de la fonction d'état. De la même manière, la fonction de mesure peut être linéarisée autour de l'état actuel estimé en utilisant les dérivées partielles de la fonction de mesure.

Un filtre de Kalman étendu présente néanmoins de nombreux inconvénients. En particulier, il ne garantit pas la convergence et ne respecte pas les invariances que peut avoir le système à estimer. Un filtre de Kalman étendu peut observer des divergences qui peuvent être initiées par des petites erreurs d'estimation de l'état. En outre, la linéarisation

**EP 4 042 197 B1**

des fonctions d'état et/ou de mesure requise à chaque itération d'un tel filtre nécessitent des moyens de calcul importants qui souvent ne sont pas disponible à bord, lorsqu'il s'agit d'un radar aéroporté, par exemple.

Pour surmonter de telles limitations du filtre de Kalman étendu, il est connu d'utiliser une variante de ce filtre, dite filtre de Kalman étendu invariant (encore désigné par l'acronyme 'IEKF'), comme par exemple décrit dans Marion Pilté, Silvère Bonnabel, and Frédéric Barbaresco, Invariant Extended Kalman Filter for Target Tracking, URSI France 2018. Un filtre IEKF tire profit des invariances que peut présenter le système à estimer. Des transformations telles que la rotation et la translation peuvent laisser un système à estimer invariant. Un filtre IEKF consiste à définir les processus stochastiques du bruit et à modifier les gains du filtre de Kalman étendu de manière à ce qu'ils respectent les invariances du système à estimer. L'IEKF présente l'avantage de considérer le bruit affectant le système à estimer comme étant indépendant de l'état prédit de la cible manœuvrante. Une telle considération permet de réduire considérable la complexité du calcul par rapport à un filtre de Kalman étendu classique. Un filtre IEKF est classiquement utilisé pour le suivi de cibles manœuvrantes au moyen d'un radar (appelé aussi 'observateur') fixe par rapport au sol.

Il existe donc un besoin pour un procédé et un dispositif améliorés d'estimation de l'état d'une cible manœuvrante implémenté dans un radar mobile par rapport au sol.

**Définition générale de l'invention**

L'invention vient améliorer la situation. A cet effet, il est proposé un procédé d'estimation de l'état d'une cible mis en œuvre dans un radar mobile évoluant dans un espace donné, le radar recevant une pluralité de signaux d'estimation relatifs à la cible, le procédé comprenant une ou plusieurs itérations, chacune des iterations étant associée à un instant donné et comprenant une étape d'application d'un filtre de Kalman étendu invariant, chaque itération fournissant une estimation de l'état de la cible représenté par des données d'état comprenant un ensemble de paramètres d'état et une matrice de covariance associée, les données d'état étant définies par rapport à un repère associé à la position du radar mobile. Chaque itération courante comprend les étapes consistant à :

- Appliquer une opération de transformation au repère, ce qui fournit un repère transformé, le repère transformé étant associé à la position du radar mobile à l'instant associé à l'itération courante,

- Mettre à jour dans le repère transformé les données d'état déterminées à l'itération précédente,

- Appliquer le filtre de Kalman étendu invariant.

L'étape d'application du filtre de Kalman étendu invariant comprend avantageusement les étapes consistant à :

- Déterminer un état estimé a priori de la cible défini dans le repère transformé à partir des données comprenant les données d'état déterminées à l'itération précédente mises à jour dans le repère transformé,

- Déterminer un état a postériori de la cible défini dans le repère transformé à partir des données comprenant les données de l'état estimé à priori de la cible et les données issues d'au moins un des signaux d'estimation.

Selon l'invention, les paramètres d'état de cible comprennent une matrice d'orientation, un paramètre de courbure définissant la courbure de la trajectoire de la cible, un paramètre de torsion, la norme d'un vecteur vitesse représentant la vitesse de la cible, et des données de position de la cible définies par des coordonnées cartésiennes.

Le radar peut fonctionner en mode actif et en mode passif. Les signaux d'estimation peuvent alors comprendre un ou plusieurs signaux d'estimation passifs séquentiellement émis par la cible manœuvrante et un ou plusieurs signaux d'estimation actifs rétrodiffusés par la cible manœuvrante en réponse à au moins un signal actif émis par le radar mobile.

Dans un mode de réalisation, le nombre de signaux d'estimation actifs est inférieur au nombre de signaux d'estimation passifs.

L'état a posteriori de la cible peut être en outre déterminé à partir de la matrice de covariance de bruit associé à chaque signal de suivi, la matrice de covariance du bruit associé à un signal d'estimation actif étant différente de la matrice de covariance du bruit associé à un signal d'estimation passif.

La cible peut évoluer dans un plan de mouvement à deux dimensions fixe au cours du temps.

Dans un mode de réalisation, les paramètres d'état peuvent comprendre un angle définissant le cap de la cible, une position cartésienne de la cible en deux dimensions, un paramètre de courbure définissant la courbure de la trajectoire de la cible et une norme d'un vecteur vitesse représentant la vitesse de déplacement de la cible manœuvrante dans le plan de mouvement.

Dans un mode de réalisation, les paramètres d'état de la cible peuvent comprendre en outre la norme du vecteur vitesse représentant la vitesse de la cible manœuvrante défini par rapport à un repère de mesure fixe et invariant au cours

3

du temps.

Un seul signal d'estimation actif parmi les signaux d'estimation peut être utilisé pour estimer l'état de la cible manœuvrante.

Dans une forme de réalisation, le procédé peut comprendre en outre la détermination de l'angle d'élévation et de l'angle d'azimut définissant la direction dans laquelle se situe la cible manœuvrante par rapport au radar mobile à partir d'un signal d'estimation passif reçu par le radar mobile.

Dans certains modes de réalisation, le procédé peut comprendre en outre la détermination d'au moins un des paramètres suivants à partir d'un signal d'estimation actif reçu par le radar mobile :

- l'angle d'élévation et l'angle d'azimut définissant la direction dans laquelle se situe la cible manœuvrante par rapport au radar mobile,
- la distance relative séparant le radar mobile de la cible,
- la vitesse radiale de la cible par rapport au radar mobile.

Dans des formes de réalisation, le radar mobile peut être aéroporté ou spatial.

Les données d'état reçues par la première itération peuvent être des données d'état d'initialisation.

Il est en outre proposé un radar mobile comprenant un dispositif d'estimation de l'état d'une cible évoluant dans un espace donné, le radar recevant une pluralité de signaux d'estimation relatifs à la cible, exécutant une ou plusieurs itérations, chacune des iterations associée à un instant donné comprenant une application d'un filtre de Kalman étendu invariant et fournissant une estimation de l'état de la cible représenté par des données d'état comprenant un ensemble de paramètres d'état et une matrice de covariance associée, les données d'état étant définies par rapport à un repère associé à la position du radar mobile audit instant, fixe pendant toute une itération, et les paramètres d'état de cible (101) comprenant une matrice d'orientation, un paramètre de courbure définissant la courbure de la trajectoire de la cible, un paramètre de torsion, la norme d'un vecteur vitesse représentant la vitesse de ladite cible, et des données de position de la cible définies par des coordonnées cartésiennes. Le dispositif d'estimation d'état est configuré pour exécuter à chaque iteration :

- Une fonction de transformation de repère apte à appliquer une opération de transformation au repère, ce qui fournit un repère transformé, le repère transformé étant associé à la position du radar mobile à l'instant associé à l'itération courante,
- Une fonction de mise à jour apte à mettre à jour dans le repère transformé les données d'état déterminées à l'itération précédente,
- Un filtre de Kalman étendu invariant.

Le filtre de Kalman étendu invariant comprend :

- Une fonction de prédiction apte à déterminer un état estimé à priori de la cible défini dans le repère transformé à partir des données comprenant les données d'état déterminées à l'itération précédente mises à jour dans le repère transformé,

- Une fonction de correction apte à déterminer un état à postériori de la cible défini dans le repère transformé à partir des données comprenant les données de l'état estimé à priori de la cible et les données issues d'au moins un des signaux de suivi.

## Brève description des figures

D'autres caractéristiques et avantages de l'invention apparaîtront à l'aide de la description qui suit et des figures annexés dans lesquels :

[Fig.1] représente un exemple de système dans lequel est implémenté un dispositif d'estimation de cible, selon des modes de réalisation de l'invention,

[Fig. 2] représente un autre exemple de système dans lequel est implémenté un dispositif d'estimation de cible, selon d'autres modes de réalisation de l'invention,

[Fig. 3] représente l'évolution de la trajectoire d'une cible manœuvrante dans un espace à trois dimensions muni d'un repère défini par un radar mobile au cours du temps, selon un mode de réalisation, et

[Fig. 4] représente un procédé d'estimation de cible, selon des modes de réalisation de l'invention.

**Description détaillée**

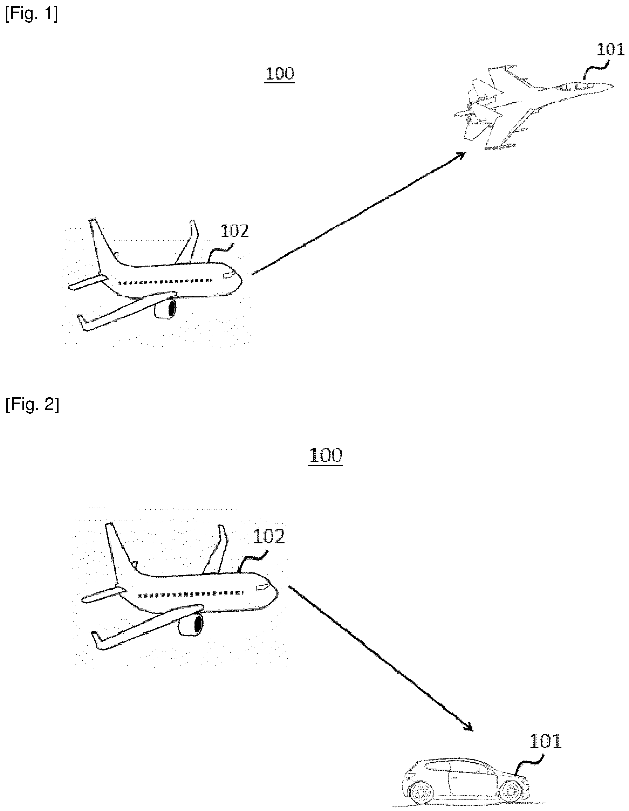

La figure 1 représente un exemple de système de suivi de l'état d'une cible 100 comprenant un radar mobile 102 équipé d'un dispositif d'estimation de l'état d'une cible manœuvrante, selon des modes de réalisation de l'invention. Le dispositif d'estimation est configuré pour suivre l'évolution au cours du temps de l'état d'une cible manœuvrante 101. La cible manœuvrante 101 peut être tout objet évoluant dans un espace à trois dimensions (3D) tel qu'un aéronef, un drone ou une fusée. Le radar mobile 102 peut être utilisé par un deuxième objet, tel qu'un aéronef, évoluant dans le même espace 3D. Le mouvement de la cible manœuvrante peut être indépendant du mouvement du radar mobile. La cible manœuvrante peut évoluer selon une ou plusieurs formes géométriques avec une vitesse de déplacement qui peut être variable au cours du temps. De telles formes géométriques peuvent comprendre des hélices, des segments de droite, etc.

Le radar mobile 102 peut être configuré pour alterner son fonctionnement entre un mode de fonctionnement actif et un mode de fonctionnement passif, d'une manière pouvant ne pas être périodique. Dans un mode de fonctionnement actif du radar mobile 102, des signaux électromagnétiques sont émis par le radar mobile 102 en direction de la cible manœuvrante 101. Des signaux électromagnétiques émis par le radar mobile 102 peuvent heurter la cible manœuvrante 101 avant d'être retournés dans la direction d'où ils proviennent, selon un principe de rétrodiffusion. Des signaux électromagnétiques rétrodiffusés par la cible manœuvrante 101 peuvent ensuite être reçus par le radar mobile 102 afin d'être analysés. Le radar mobile 102 peut être configuré pour déterminer une pluralité de paramètres sur la position de la cible manœuvrante à partir des signaux électromagnétiques rétrodiffusés. De tels paramètres peuvent comprendre les angles d'azimut et d'élévation définissant la direction dans laquelle la cible manœuvrante 101 se situe, la distance séparant le radar mobile 102 de la cible manœuvrante 101, et la vitesse radiale relative de la cible manœuvrante 101 par rapport au radar mobile 102.

Dans un mode de fonctionnement passif du radar mobile 102, le radar mobile 102 n'émet pas de signaux électromagnétiques en direction de la cible manœuvrante 101 et analyse directement les signaux pouvant être émis délibérément par la cible manœuvrante 101. Le radar mobile 102 peut déterminer la direction dans laquelle se situe la cible manœuvrante 101 définie par les angles d'azimut et d'élévation par rapport à la position du radar mobile 102 en analysant un signal émis par la cible manœuvrante 101. Un mode de fonctionnement passif du radar mobile 102 présente l'avantage de permettre un suivi discret de la cible manœuvrante 101. Dans un tel mode de fonctionnement, le radar mobile 102 détermine moins de paramètres sur la position de la cible manœuvrante 101 que dans un mode de fonctionnement actif.

Des modes de réalisation de l'invention peuvent mettre en œuvre les deux modes de fonctionnement du radar mobile 102 de sorte à disposer fréquemment de mesures passives et occasionnellement de mesures actives. Par exemple, une mesure passive peut être acquise toutes les une ou deux secondes tandis qu'une mesure active peut être effectuée chaque minute. Lorsqu'un signal d'estimation actif et un signal d'estimation passif sont reçus au même instant pour effectuer une estimation de l'état de la cible, le radar peut être configuré pour ne traiter que le signal actif qui permet de déterminer plus de paramètres sur la position de la cible qu'un signal d'estimation passif. La réception par le radar de signaux d'estimation peut être effectuée d'une façon irrégulière dans le temps. En l'absence de signaux d'estimation passifs émis délibérément par la cible à suivre, le radar peut être configuré pour utiliser les signaux d'estimation actifs qu'il génère pour maintenir le suivi de l'état de la cible.

Dans d'autres modes de réalisation de l'invention, le radar mobile 102 peut être configuré pour fonctionner selon un mode de fonctionnement actif seulement. Un tel mode de fonctionnement est avantageux lorsque la cible manœuvrante n'émet pas de signaux électromagnétiques ou lorsque l'affaiblissement de la puissance des signaux émis par la cible manœuvrante empêche leur détection et leur exploitation par le radar mobile. L'affaiblissement de la puissance de signaux électromagnétiques est proportionnel à leur fréquence et à la distance séparant la cible manœuvrante 101 du radar mobile 102.

Alternativement, le radar mobile peut être configuré pour fonctionner selon un mode de fonctionnement passif seulement. Un tel mode de fonctionnement présente l'avantage de permettre un suivi discret.

La figure 2 représente un autre exemple de système 100 dans lequel un dispositif d'estimation de l'état d'une cible manœuvrante 101 peut être implémenté, selon des modes de réalisation de l'invention. Dans l'exemple de la figure 2, la cible manœuvrante 101 peut évoluer dans un plan à deux dimensions (2D). La cible manœuvrante 101 peut être terrestre, comme par exemple une voiture ou un bâtiment de surface (navire ou autre). La cible 101 peut être en variante une cible aéroportée ramenée à un modèle d'évolution en 2D lorsque son mouvement s'effectue constamment dans un plan à deux dimensions. Le mouvement de la cible manœuvrante 101 dans un plan à deux dimensions peut par exemple suivre une trajectoire rectiligne ou sinusoïdale. La cible manœuvrante 101 peut à tout instant changer les caractéristiques de sa trajectoire. De telles caractéristiques peuvent comprendre la forme géométrique de la trajectoire et la vitesse de déplacement.

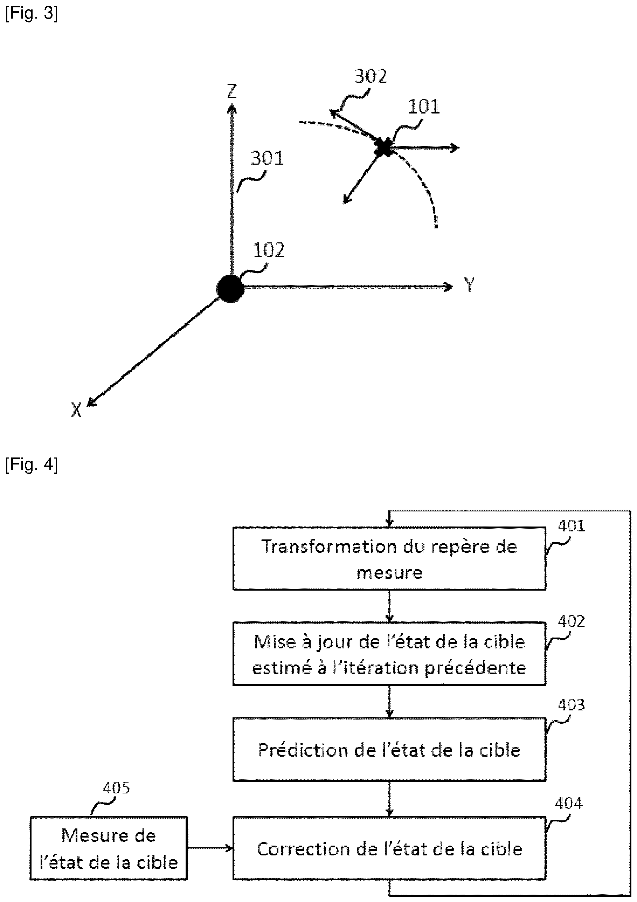

La figure 3 est un schéma représentant des paramètres d'état de la cible manœuvrante 101 lorsque la cible évolue dans un espace à trois dimensions associé à un repère de mesure (301) dont le centre correspond à la position du radar mobile 102, selon certains modes de réalisation de l'invention.

L'état de la cible 101 est représenté par des données d'état comprenant un ensemble de paramètres d'état et une matrice de covariance associée aux paramètres d'état. Les données d'état peuvent être toutes définies par rapport à un même repère de mesure. Alternativement, certaines données d'état peuvent être définies dans un repère de mesure différent par rapport à d'autres données d'état.

D'après l'invention, les paramètres d'état de la cible comprennent une matrice d'orientation $R_t$ qui peut définir un repère dont les vecteurs de base constituent un trièdre Frenet-Serret lié à la cible manœuvrante 101. L'origine d'un tel trièdre peut être défini par la position de la cible 101, les vecteurs de base du trièdre étant unitaires, orthogonaux deux à deux et comprenant :

- un vecteur tangent $\vec{T}$ à la trajectoire et colinéaire au vecteur vitesse de la cible (en supposant que la trajectoire se fait sans glissement),
- un vecteur normal N orienté vers le centre de courbure locale de la trajectoire, et
- un vecteur binomial B complète le trièdre de sorte à obtenir une base orthonormée. Les paramètres d'état de la cible comprennent un paramètre de courbure de la trajectoire $\gamma_t$ et un paramètre de torsion $\tau_t$. Le paramètre de courbure de la trajectoire représente la tendance de la cible manœuvrante 101 à s'écarter du plan osculateur. Les deux paramètres de courbure et de torsion régissent l'évolution de la matrice d'orientation suivant les relations suivantes :

$$\frac{d\vec{T}}{dt} = \gamma_t \vec{N}; \; \frac{d\vec{N}}{dt} = -\gamma_t \vec{T} + \tau_t \vec{B}; \; \frac{d\vec{B}}{dt} = -\tau_t \vec{N} \qquad (1)$$

Les paramètres d'état de la cible manœuvrante 101 comprennent en outre la position de la cible en coordonnées cartésiennes $x_t$ définie dans le repère de mesure 301 et la norme $u_t$ du vecteur vitesse de la cible.

Les paramètres d'état de la cible définis à un instant t peuvent ainsi être représentés par le vecteur $X_t$ suivant :

$$X_t = (R_t \quad x_t \quad \gamma_t \quad \tau_t \quad u_t) \qquad (2)$$

L'évolution au cours du temps des paramètres d'état de la cible manœuvrante 101 peut être déterminée à partir de l'évolution des axes de la matrice d'orientation donnée par la relation (1), en considérant que la cible obéit à des commandes constantes par morceaux. De telles commandes sont représentées par les paramètres de courbure $\gamma_t$ et de torsion $\tau_t$ et la norme du vecteur vitesse $u_t$.

Les variations des paramètres d'état de la cible manœuvrante 101 peuvent être représentées par les dérivées suivantes :

$$\frac{dx_t}{dt} = R_t v_t + w_t^x; \frac{dR_t}{dt} = R_t(w_t + w_t^\omega)_\times; \frac{d\gamma_t}{dt} = 0 + w_t^\gamma; \frac{d\tau_t}{dt} = 0 + w_t^\tau; \frac{du_t}{dt} = 0 + w_t^u \quad (3)$$

Dans l'équation (3) :

- $(a)_\times$ de $R^{3\times3}$ désigne la matrice antisymétrique associée à un vecteur a de $R^3$ de telle sorte que pour un vecteur b de $\mathbb{R}^3 : (a)_\times b = a \wedge b$,

-

$$v_t = (u_t \quad 0 \quad 0),$$

-

$$\omega_t = (\tau_t \quad 0 \quad u_t),$$

et

- Chacun des éléments $w_t^x, w_t^\omega, w_t^\gamma, w_t^\tau, w_t^u$ représente un bruit blanc additif gaussien.

Les paramètres d'état de la cible manœuvrante 101 comprennent deux groupes de paramètres d'état. Un premier groupe de paramètres d'état comprend la matrice d'orientation $R_t$ et la position de la cible $x_t$. Le premier groupe de paramètres d'état peut être représenté par une matrice carrée $\chi_t$ dépendant de la matrice d'orientation $R_t$ et de la position de la cible $x_t$, telle que :

$$\chi_t = \begin{pmatrix} R_t & \mathrm{x}_t \\ 0_{1,3} & 1 \end{pmatrix} \qquad (4)$$

Le deuxième groupe de paramètres d'état comprend le paramètre de courbure $\gamma_t$, le paramètre de torsion $\tau_t$ et la norme du vecteur vitesse $u_t$ de la cible. Le deuxième groupe de paramètres d'état peut être représenté par une matrice $\zeta_t$ dépendant du paramètre de courbure $\gamma_t$, du paramètre de torsion $\tau_t$ et de la norme du vecteur vitesse $u_t$ de la cible, telle que :

$$\zeta_t = \begin{pmatrix} \gamma_t \\ \tau_t \\ u_t \end{pmatrix} \qquad (5)$$

Selon d'autres modes de réalisation de l'invention, la cible manœuvrante 101 peut évoluer dans un plan à deux dimensions (2D). Dans tels modes de réalisation, l'état de la cible peut être décrit par des paramètres d'état comprenant les cordonnées cartésiennes $x_t$ de la cible en 2D, la courbure de la trajectoire $\gamma_t$, le cap de la cible $\theta$, **la vitesse** de changement de cap $\gamma = \dfrac{\mathrm{d}\theta}{\mathrm{d}t}$ et la norme du vecteur vitesse u. Les paramètres d'état de la cible peuvent être représentés par un vecteur d'état ayant comme composantes : $x_t$, $\gamma_t$, 0, y, u .

La figure 4 est un organigramme représentant les étapes mises en œuvre dans le procédé d'estimation de l'état d'une cible manœuvrante 101, selon certains modes de réalisation de l'invention. Le procédé d'estimation de l'état d'une cible manœuvrante 101 peut avantageusement être implémenté dans un radar 102 mobile par rapport au sol configuré pour recevoir des mesures passives et/ou des mesures actives de la position de la cible manœuvrante 101. Un tel procédé est récursif et peut comprendre une ou plusieurs itérations d'un ensemble d'étapes.

Le procédé d'estimation de l'état d'une cible est basé sur un filtre de Kalman étendu invariant et comprend en plus une étape de transformation 401 du repère de mesure 301 et une étape de mise à jour 402 de l'état de la cible manœuvrante 101 déjà estimé lors d'une précédente itération du procédé d'estimation dans le repère de mesure transformé 301. La transformation du repère de mesure 301 à chaque itération permet de manipuler les états estimés a priori et a posteriori de la cible 101 et une position mesurée définis par rapport à un même repère de mesure 301. Une telle transformation du repère permet de réduire considérablement la complexité du calcul. Le procédé d'estimation peut comprendre en outre une étape de redéfinition de certains paramètres de l'état de la cible manœuvrante 101 dans un repère de mesure absolu (étape non représentée sur la figure 4). Une telle étape de redéfinition de certains paramètres peut être effectuée après l'étape de correction du filtre de Kalman étendu invariant 404. Le fonctionnement du procédé d'estimation tel que décrit en référence à la figure 4 peut être effectué selon un système à temps discret consistant à associer un instant de temps $t_k$ à chaque itération du procédé. L'intervalle de temps entre deux instants successifs, $t_{k-1}$ et $t_k$, peut ne pas être constant. L'itération associée à un instant $t_k$ peut recevoir l'état estimé lors de l'itération précédente. En outre, la première itération du procédé d'estimation représenté par la figure 4 peut recevoir un état d'initialisation de la cible. Un tel état d'initialisation peut être configuré pour garantir la convergence du procédé d'estimation de l'état de la cible.

Selon l'étape de transformation du repère de mesure 401, un nouveau repère de mesure 301 (encore appelé repère transformé) peut être défini entre les instants $t_{k-1}$ et $t_k$. Le repère transformé 301 peut avoir comme origine la position où se situera le radar à l'instant $t_k$ associé à l'itération courante du procédé d'estimation de l'état de la cible. Une telle position peut être connue avec précision à l'avance. Les trois axes du repère transformé 301 peuvent être orientés dans les directions respectives East, Nord et Haut. Le changement de repère de mesure 301 peut donc impliquer une rotation par rapport au précédent repère de mesure 301. Le repère transformé 301 défini par son origine et son système d'axe $(O_k, \vec{e}_k, \vec{n}_k, \vec{u}_k)$ peut être défini à partir du précédent repère de mesure 301 $(O_{k-1}, \vec{e}_{k-1}, \vec{n}_{k-1}, \vec{u}_{k-1})$ selon les relations suivantes :

$$\overrightarrow{O_{k-1}O_k} = o_x\vec{e}_{k-1} + o_y\vec{n}_{k-1} + o_z\vec{u}_{k-1} \qquad (6.1)$$

$$\vec{e}_{k-1} = e_x\vec{e}_k + e_y\vec{n}_k + e_z\vec{u}_k \qquad (6.2)$$

$$\vec{n}_{k-1} = n_x \vec{e}_k + n_y \vec{n}_k + n_z \vec{u}_k \qquad (6.3)$$

$$\vec{u}_{k-1} = u_x \vec{e}_k + u_y \vec{n}_k + u_z \vec{u}_k \qquad (6.4)$$

Les éléments $o_x$, $o_y$, $o_z$, $e_x$, $e_y$, $e_z$, $n_x$, $n_y$, $n_z$, $u_x$, $u_y$ et $u_z$ peuvent être des nombres réels, la valeur de ces nombres pouvant changer d'une itération à une autre.

L'étape de changement de repère de mesure 401 peut être suivie d'une étape de mise à jour de l'état de la cible 402 tel que estimé à l'itération précédente $t_{k-1}$ dans le repère transformé 301. Dans un mode de réalisation, les paramètres d'état de la cible manœuvrante 101 évoluant dans un espace à 3 dimensions qui peuvent être redéfinis dans le repère transformé 301 peuvent comprendre la matrice d'orientation $R_t$ et la position de la cible définie par ses coordonnées cartésiennes $x_t$. Dans l'étape de mise à jour 402, l'état de la cible peut être redéfini en utilisant une matrice de changement de repère $M_{k-1}^k$ définie par les éléments suivants :

$$M_{k-1}^k = \begin{pmatrix} e_x & n_x & u_x \\ e_y & n_y & u_y \\ e_z & n_z & u_z \end{pmatrix} \qquad (7)$$

La matrice d'orientation estimée à l'itération $t_{k-1}$ du procédé d'estimation peut être mise à jour dans le repère transformé 301, selon la relation suivante :

$$\left(\widehat{R}_{k-1|k-1}\right)_{\text{repère à } t_k} = M_{k-1}^k \left(\widehat{R}_{k-1|k-1}\right)_{\text{repère à } t_{k-1}} \qquad (8)$$

De manière similaire, la position de la cible manœuvrante 101 estimée à l'itération $t_{k-1}$ du procédé d'estimation peut être redéfinie dans le repère transformé 301, selon la relation suivante :

$$\left(\hat{x}_{k-1|k-1}\right)_{\text{repère à } t_k} = M_{k-1}^k \left( \left(\hat{x}_{k-1|k-1}\right)_{\text{repère à } t_{k-1}} - \begin{pmatrix} o_x \\ o_y \\ o_z \end{pmatrix} \right) \qquad (9)$$

Des paramètres d'état de la cible manœuvrante 101 peuvent être associés au repère transformé 301 sans subir aucune transformation. De tels paramètres peuvent comprendre les paramètres de courbure $\gamma_t$ et de torsion $\tau_t$ et la norme du vecteur vitesse $u_t$ de la cible.

L'état de la cible ainsi mis à jour dans le repère transformé 301 peut être ensuite utilisé pour appliquer un filtre de Kalman étendu invariant selon les étapes 403 et 404.

L'application d'un filtre de Kalman comprend une étape de prédiction 403 et une étape de correction 404. A l'étape de prédiction 403, une prédiction de l'état de la cible est effectuée en utilisant l'état de la cible estimé à l'itération précédente $t_{k-1}$, tel que redéfinie dans le repère transformé 301, et une équation d'état régissant l'évolution de la trajectoire de la cible en tenant compte des invariances qui caractérisent une telle évolution. L'étape de prédiction 403 fournit un état a priori de la cible et une matrice de covariance associée. L'état de la cible prédit, comprenant un ensemble de paramètres d'état et une matrice de covariance associée, peut être défini par rapport au repère de mesure transformé 301.

Dans l'étape 403 de prédiction de l'état de la cible manœuvrante 101 évoluant dans un espace à trois dimensions, les équations suivantes sont résolues pour passer des estimations faites à l'instant $t_{k-1}$ aux estimations faites à l'instant $t_k$:

$$\frac{d\widehat{\chi}_t}{dt} = \widehat{\chi}_t \widehat{v}_t, \quad \frac{d\widehat{\zeta}_t}{dt} = 0 \qquad (10)$$

Dans l'équation (10), $v_t$ désigne une matrice carrée d'ordre quatre définie par les paramètres d'état de la cible $\zeta_t$ selon la relation suivante :

$$v_t = \begin{pmatrix} 0 & -\gamma_t & 0 & u_t \\ \gamma_t & 0 & -\tau_t & 0 \\ 0 & \tau_t & 0 & 0 \\ 0 & 0 & 0 & 0 \end{pmatrix} \qquad (11)$$

La matrice de covariance associée aux paramètres d'état estimés peut être déterminée en résolvant l'équation de Riccati donnée par la relation suivante :

$$\frac{dP_t}{dt} = A_t P_t + P_t A_t^{T} + Q_t \qquad (12)$$

Dans l'équation (12), $Q_t$ désigne une matrice de covariance du bruit d'état et $A_t$ désigne une matrice d'évolution donnée par la relation suivante :

$$A_t = \begin{pmatrix} -\begin{pmatrix} \hat{\tau}_t \\ 0 \\ \hat{\gamma}_t \end{pmatrix}_\times & 0_{3,3} & \begin{matrix} 0 & 1 & 0 \\ 0 & 0 & 0 \\ 1 & 0 & 0 \end{matrix} \\ -\begin{pmatrix} \hat{u}_t \\ 0 \\ 0 \end{pmatrix}_\times & -\begin{pmatrix} \hat{\tau}_t \\ 0 \\ \hat{\gamma}_t \end{pmatrix}_\times & \begin{matrix} 0 & 0 & 1 \\ 0 & 0 & 0 \\ 0 & 0 & 0 \end{matrix} \\ 0_{3,3} & 0_{3,3} & 0_{3,3} \end{pmatrix} \qquad (13)$$

Dans l'étape de correction 404, les données d'état de la cible estimées à priori comprenant l'ensemble de paramètres d'état et la matrice de covariance associée, tels que déterminés à l'étape 403, sont utilisés. L'étape de correction peut utiliser en outre une mesure de l'état de la cible, déterminée à l'étape 405, qui peut être incomplète et/ou bruité ainsi qu'une matrice de covariance associée au bruit de mesure.

Dans l'étape de correction 404, un paramètre d'erreur et un gain de Kalman sont d'abord calculés. L'état a posteriori de la cible peut être ensuite estimé en tenant compte de la mesure de l'état de la cible déterminée à l'étape 405. Une matrice de covariance associée à l'état de la cible a posteriori est ensuite estimée.

Le paramètre d'erreur peut être défini comme la différence entre l'état mesuré de la cible et son état prédit. Le calcul du paramètre d'erreur peut utiliser un paramètre parmi les paramètres d'état de la cible manœuvrante. Dans les modes de réalisation de l'invention, le calcul du paramètre d'erreur peut utiliser la position estimée de $x_t$ et la position mesurée $Y_k$ de l'état de la cible selon la relation suivante :

$$z_k = \widehat{R_{t_k}}\left(Y_k - \widehat{x_{t_k}}\right) \qquad (14)$$

La position estimée et la position mesurée sont définies par rapport à un même repère de mesure qui peut être le repère transformé 301. Lorsque l'itération courante du procédé d'estimation de l'état de la cible est associée à un signal d'estimation actif, la position mesurée peut être déterminée à partir d'un ou de plusieurs paramètres de position fournis par un signal d'estimation actif. De tels paramètres de position comprennent dans un tel mode de réalisation la distance séparant le radar mobile de la cible manœuvrante. Alternativement, lorsque l'itération courante est associée à un signal d'estimation passif, la position mesurée peut être déterminée à partir d'au moins les angles d'élévation et d'azimut fournis par un signal d'estimation passif. Un tel mode de fonctionnement passif peut utiliser une ou plusieurs techniques de localisation pour remonter à la position de la cible manœuvrante. De telles techniques de localisation peuvent comprendre une analyse de l'angle d'arrivée et une analyse de la puissance du signal reçu.

Le gain de Kalman peut être déterminé en utilisant la relation suivante :

$$L_k = P_{t_k} H^T (H P_{t_k} H^T + \widehat{R_{t_k}} N \widehat{R_{t_k}}^T)^{-1} \qquad (15)$$

Dans l'équation (15), la matrice $H$ est définie par $H = (0_{3,3}\ I_3\ 0_{3,3})$.

L'état de la cible manœuvrante 101 estimé a posteriori peut ensuite être calculé selon l'équation (16) :

$$\widehat{\chi_{t_k}}^+ = \widehat{\chi_{t_k}} \exp((L_k z_k)_{1:6}), \qquad \widehat{\zeta_{t_k}}^+ = \widehat{\zeta_{t_k}} + (L_k z_k)_{7:9} \qquad (16)$$

La matrice de covariance associée à l'état estimé a posteriori peut ensuite être effectuée en calculant :

$$\widehat{P_{t_k}}^+ = (I_9 - L_k H) P_{t_k} \qquad (17)$$

Selon des modes de réalisation de l'invention, les paramètres d'état de la cible manœuvrante peuvent comprendre la norme du vecteur vitesse de la cible définie par rapport à un référentiel absolu qui peut être le référentiel terrestre. Une telle norme du vecteur vitesse peut être obtenue à partir du vecteur vitesse du radar mobile par rapport au sol et du vecteur vitesse de la cible manœuvrante par rapport au radar mobile. Le vecteur vitesse du radar mobile par rapport au sol peut être déterminé avec exactitude par le radar mobile lui-même.

L'homme du métier comprendra que le procédé d'estimation et d'estimation d'état de cible selon les modes de réalisation peut être mis en œuvre de diverses manières par matériel (« hardware »), logiciel, ou une combinaison de matériel et de logiciels, notamment sous la forme de code de programme pouvant être distribué sous la forme d'un produit de programme, sous diverses formes. En particulier, le code de programme peut être distribué à l'aide de supports lisibles par ordinateur, qui peuvent inclure des supports de stockage lisibles par ordinateur et des supports de communication. Les procédés décrits dans la présente description peuvent être notamment implémentés sous la forme d'instructions de programme d'ordinateur exécutables par un ou plusieurs processeurs dans un dispositif informatique d'ordinateur. Ces instructions de programme d'ordinateur peuvent également être stockées dans un support lisible par ordinateur.

**Revendications**

1. Procédé d'estimation de l'état d'une cible (101) mis en œuvre dans un radar mobile (102) évoluant dans un espace donné, ledit radar recevant une pluralité de signaux d'estimation relatifs à ladite cible (101), le procédé comprenant une ou plusieurs itérations, chacune desdites itérations étant associée à un instant donné et comprenant une étape d'application d'un filtre de Kalman étendu invariant, chaque itération fournissant une estimation de l'état de la cible représenté par des données d'état comprenant un ensemble de paramètres d'état et une matrice de covariance associée, lesdites données d'état étant définies par rapport à un repère associé à la position dudit radar mobile audit instant, fixe pendant toute une itération, et les paramètres d'état de cible (101) comprenant une matrice d'orientation, un paramètre de courbure définissant la courbure de la trajectoire de la cible, un paramètre de torsion, la norme d'un vecteur vitesse représentant la vitesse de ladite cible, et des données de position de la cible définies par des coordonnées cartésiennes, le procédé étant **caractérisé en ce que** chaque itération courante comprend les étapes consistant à :

   - Appliquer une opération de transformation au repère (401), ce qui fournit un repère transformé, le repère transformé étant associé à la position du radar mobile à l'instant associé à l'itération courante,
   - Mettre à jour (402) dans le repère transformé les données d'état déterminées à l'itération précédente,
   - Appliquer le filtre de Kalman étendu invariant (403, 404),

   ladite étape d'application du filtre de Kalman étendu invariant comprenant les étapes consistant à :

   - Déterminer un état estimé a priori (403) de la cible défini dans le repère transformé à partir des données comprenant les données d'état déterminées à l'itération précédente mises à jour dans le repère transformé,
   - Déterminer un état a posteriori de la cible (404) défini dans le repère transformé à partir des données comprenant les données de l'état estimé à priori de la cible et les données issues d'au moins un des signaux d'estimation.

2. Procédé d'estimation de l'état d'une cible selon la revendication 1, **caractérisé en ce que** le radar fonctionne en mode actif et en mode passif, et **en ce que** lesdits signaux d'estimation comprennent un ou plusieurs signaux d'estimation passifs séquentiellement émis par ladite cible manœuvrante (101) et un ou plusieurs signaux d'estimation actifs rétrodiffusés par ladite cible manœuvrante en réponse à au moins un signal actif émis par le radar mobile (102).

3. Procédé d'estimation de l'état d'une cible selon la revendication 2, **caractérisé en ce que** le nombre de signaux d'estimation actifs est inférieur au nombre de signaux d'estimation passifs.

**4.** Procédé d'estimation de l'état d'une cible selon la revendication 3, **caractérisé en ce que** l'état a posteriori de ladite cible est en outre déterminé à partir de la matrice de covariance de bruit associé à chaque signal de suivi, la matrice de covariance du bruit associé à un signal d'estimation actif étant différente de la matrice de covariance du bruit associé à un signal d'estimation passif.

**5.** Procédé d'estimation de l'état d'une cible selon l'une des revendications précédentes 2 à 4, **caractérisé en ce que** ledit paramètre de torsion est maintenu sensiblement égal à zéro.

**6.** Procédé d'estimation de l'état d'une cible selon la revendication 5, **caractérisé en ce que** les paramètres d'état comprennent un angle définissant le cap de la cible, une position cartésienne de la cible en deux dimensions, un paramètre de courbure définissant la courbure de la trajectoire de la cible et une norme d'un vecteur vitesse représentant la vitesse de déplacement de la cible manœuvrante (101) dans ledit plan de mouvement.

**7.** Procédé d'estimation de l'état d'une cible selon l'une quelconque des revendication précédentes, **caractérisé en ce que** les paramètres d'état de la cible comprennent en outre la norme du vecteur vitesse représentant la vitesse de la cible manœuvrante (101) défini par rapport à un repère de mesure fixe et invariant au cours du temps.

**8.** Procédé d'estimation de l'état d'une cible selon l'une des revendications 2 à 7, **caractérisé en ce qu'**un seul signal d'estimation actif parmi lesdits signaux d'estimation est utilisé pour estimer l'état de la cible manœuvrante (101).

**9.** Procédé d'estimation de l'état d'une cible selon l'une quelconque des revendications précédentes, **caractérisé en ce qu'**il comprend en outre la détermination de l'angle d'élévation et de l'angle d'azimut définissant la direction dans laquelle se situe la cible manœuvrante (101) par rapport audit radar mobile (102) à partir d'un signal d'estimation passif reçu par le radar mobile (102).

**10.** Procédé d'estimation de l'état d'une cible selon l'une des revendications précédentes, **caractérisé en ce qu'**il comprend en outre la détermination d'au moins un des paramètres suivants à partir d'un signal d'estimation actif reçu par le radar mobile (102) :

- l'angle d'élévation et l'angle d'azimut définissant la direction dans laquelle se situe la cible manœuvrante (101) par rapport audit radar mobile (102),
- la distance relative séparant le radar mobile (102) de la cible (101),
- la vitesse radiale de la cible (101) par rapport audit radar mobile (102).

**11.** Procédé d'estimation de l'état d'une cible selon l'une quelconque des revendications précédentes, **caractérisé en ce que** le radar mobile (102) est aéroporté ou spatial.

**12.** Procédé d'estimation de l'état d'une cible selon l'une quelconque des revendications précédentes, **caractérisé en ce que** les données d'état reçues par la première itération sont des données d'état d'initialisation.

**13.** Radar mobile (102) comprenant un dispositif d'estimation de l'état d'une cible (101) évoluant dans un espace donné, ledit radar recevant une pluralité de signaux d'estimation relatifs à ladite cible (101), exécutant une ou plusieurs itérations, chacune desdites itérations associée à un instant donné comprenant une application d'un filtre de Kalman étendu invariant et fournissant une estimation de l'état de la cible représenté par des données d'état comprenant un ensemble de paramètres d'état et une matrice de covariance associée, lesdites données d'état étant définies par rapport à un repère associé à la position dudit radar mobile audit instant, fixe pendant toute une itération, et les paramètres d'état de cible (101) comprenant une matrice d'orientation, un paramètre de courbure définissant la courbure de la trajectoire de la cible, un paramètre de torsion, la norme d'un vecteur vitesse représentant la vitesse de ladite cible, et des données de position de la cible définies par des coordonnées cartésiennes, le radar étant **caractérisé en ce que** ledit dispositif d'estimation d'état est configuré pour exécuter à chaque itération :

- Une fonction de transformation de repère apte à appliquer une opération de transformation au repère, ce qui fournit un repère transformé, le repère transformé étant associé à la position du radar mobile à l'instant associé à l'itération courante,
- Une fonction de mise à jour apte à mettre à jour dans le repère transformé les données d'état déterminées à l'itération précédente,
- Un filtre de Kalman étendu invariant,

ledit filtre de Kalman étendu invariant comprenant :

- Une fonction de prédiction apte à déterminer un état estimé à priori de la cible défini dans le repère transformé à partir des données comprenant les données d'état déterminées à l'itération précédente mises à jour dans le repère transformé,
- Une fonction de correction apte à déterminer un état à postériori de la cible défini dans le repère transformé à partir des données comprenant les données de l'état estimé à priori de la cible et les données issues d'au moins un des signaux de suivi.

**Patentansprüche**

1. Verfahren zur Schätzung des Zustands eines Ziels (101), das in einem mobilen Radar (102) umgesetzt wird, das sich in einem gegebenen Raum bewegt, wobei das Radar eine Vielzahl von Schätzungssignalen in Bezug auf das Ziel (101) empfängt, wobei das Verfahren eine oder mehrere Iterationen umfasst, wobei jede der Iterationen einem gegebenen Zeitpunkt zugeordnet ist und einen Schritt des Anwendens eines erweiterten invarianten Kalman-Filters umfasst, wobei jede Iteration eine Schätzung des Zustands des Ziels liefert, der durch Zustandsdaten dargestellt wird, die einen Satz von Zustandsparametern und eine zugehörige Kovarianzmatrix umfassen, wobei die Zustandsdaten in Bezug auf eine Markierung definiert sind, die der Position des mobilen Radars zu diesem Zeitpunkt zugeordnet ist, das während einer gesamten Iteration fest ist, und wobei die Zielzustandsparameter (101) eine Orientierungsmatrix umfassen, einen Krümmungsparameter, der die Krümmung der Flugbahn des Ziels definiert, einen Torsionsparameter, den Normwert eines Geschwindigkeitsvektors, der die Geschwindigkeit des Ziels darstellt, und Positionsdaten des Ziels, die durch kartesische Koordinaten definiert sind, wobei das Verfahren **dadurch gekennzeichnet ist, dass** jede aktuelle Iteration Schritte umfasst, bestehend aus:

   - Anwenden einer Transformationsoperation auf die Markierung (401), wodurch eine transformierte Markierung bereitgestellt wird, wobei die transformierte Markierung der Position des mobilen Radars zum Zeitpunkt der aktuellen Iteration zugeordnet ist,
   - Aktualisieren (402) der in der transformierten Markierung in der vorherigen Iteration ermittelten Zustandsdaten,
   - Anwenden des erweiterten invarianten Kalman-Filters (403, 404),

   wobei der Schritt des Anwendens des erweiterten invarianten Kalman-Filters die Schritte umfasst, bestehend aus:

   - Bestimmen eines a priori geschätzten Zustands (403) des Ziels, der in der transformierten Markierung definiert ist, ausgehend von den Daten, die die in der vorherigen Iteration ermittelten und in der transformierten Markierung aktualisierten Zustandsdaten umfassen,
   - Bestimmen eines a posteriori-Zustands des Ziels (404), der in der transformierten Markierung definiert ist, ausgehend von den Daten, die die Daten des a priori geschätzten Zustands des Ziels und die Daten aus mindestens einem der Schätzungssignale umfassen.

2. Verfahren zur Schätzung des Zustands eines Ziels nach Anspruch 1, **dadurch gekennzeichnet, dass** das Radar im aktiven Modus und im passiven Modus arbeitet, und dass die Schätzungssignale ein oder mehrere passive Schätzungssignale, die sequenziell von dem manövrierenden Ziel (101) ausgesendet werden, und ein oder mehrere aktive Schätzungssignale, die von dem manövrierenden Ziel als Reaktion auf mindestens ein vom mobilen Radar (102) ausgesendetes aktives Signal zurückgestreut werden, umfassen.

3. Verfahren zur Schätzung des Zustands eines Ziels nach Anspruch 2, **dadurch gekennzeichnet, dass** die Anzahl der aktiven Schätzungssignale geringer ist als die Anzahl der passiven Schätzungssignale.

4. Verfahren zur Schätzung des Zustands eines Ziels nach Anspruch 3, **dadurch gekennzeichnet, dass** der a posteriori-Zustand des Ziels weiter aus der Kovarianzmatrix des Rauschens ermittelt wird, das jedem Verfolgungssignal zugeordnet ist, wobei die Kovarianzmatrix des Rauschens, das einem aktiven Schätzungssignal zugeordnet ist, sich von der Kovarianzmatrix des Rauschens unterscheidet, das einem passiven Schätzungssignal zugeordnet ist.

5. Verfahren zur Schätzung des Zustands eines Ziels nach einem der vorstehenden Ansprüche 2 bis 4, **dadurch gekennzeichnet, dass** der Torsionsparameter im Wesentlichen gleich Null gehalten wird.

**6.** Verfahren zur Schätzung des Zustands eines Ziels nach Anspruch 5, **dadurch gekennzeichnet, dass** die Zustandsparameter einen Winkel, der den Kurs des Ziels definiert, eine kartesische Position des Ziels in zwei Dimensionen, einen Krümmungsparameter, der die Krümmung der Flugbahn des Ziels definiert, und eine Norm eines Geschwindigkeitsvektors, der die Bewegungsgeschwindigkeit des manövrierenden Ziels (101) in der Bewegungsebene darstellt, umfassen.

**7.** Verfahren zur Schätzung des Zustands eines Ziels nach einem der vorstehenden Ansprüche, **dadurch gekennzeichnet, dass** die Zustandsparameter des Ziels weiter die Norm des Geschwindigkeitsvektors umfassen, der die Geschwindigkeit des manövrierenden Ziels (101) darstellt, definiert in Bezug auf eine feste und zeitlich invariante Messmarkierung.

**8.** Verfahren zur Schätzung des Zustands eines Ziels gemäß einem der Ansprüche 2 bis 7, **dadurch gekennzeichnet, dass** ein einziges aktives Schätzungssignal unter den Schätzungssignalen verwendet wird, um den Zustand des manövrierenden Ziels (101) zu schätzen.

**9.** Verfahren zur Schätzung des Zustands eines Ziels nach einem der vorstehenden Ansprüche, **dadurch gekennzeichnet, dass** es weiter die Bestimmung des Elevationswinkels und des Azimutwinkels umfasst, die die Richtung definieren, in der sich das manövrierende Ziel (101) in Bezug auf das mobile Radar (102) befindet, ausgehend von einem passiven Schätzungssignal, das vom mobilen Radar (102) empfangen wird.

**10.** Verfahren zur Schätzung des Zustands eines Ziels nach einem der vorstehenden Ansprüche, **dadurch gekennzeichnet, dass** es weiter die Bestimmung mindestens eines der folgenden Parameter aus einem vom mobilen Radar (102) empfangenen aktiven Schätzungssignal umfasst:

- den Elevationswinkel und den Azimutwinkel, die die Richtung definieren, in der sich das manövrierende Ziel (101) in Bezug auf das mobile Radar (102) befindet,
- die relative Entfernung zwischen dem mobilen Radar (102) und dem Ziel (101),
- die Radialgeschwindigkeit des Ziels (101) in Bezug auf das mobile Radar (102).

**11.** Verfahren zur Schätzung des Zustands eines Ziels nach einem der vorstehenden Ansprüche, **dadurch gekennzeichnet, dass** das mobile Radar (102) luft- oder weltraumgestützt ist.

**12.** Verfahren zur Schätzung des Zustands eines Ziels nach einem der vorstehenden Ansprüche, **dadurch gekennzeichnet, dass** die in der ersten Iteration empfangenen Zustandsdaten Initialisierungszustandsdaten sind.

**13.** Mobiles Radar (102), umfassend eine Vorrichtung zur Schätzung des Zustands eines sich in einem gegebenen Raum bewegenden Ziels (101), wobei das Radar eine Vielzahl von Schätzungssignalen in Bezug auf das Ziel (101) empfängt, eine oder mehrere Iterationen durchführt, wobei jede der Iterationen, die einem gegebenen Zeitpunkt zugeordnet ist, eine Anwendung eines erweiterten invarianten Kalman-Filters umfasst und eine Schätzung des Zustands des Ziels liefert, der durch Zustandsdaten dargestellt wird, die einen Satz von Zustandsparametern und eine zugehörige Kovarianzmatrix umfassen, wobei die Zustandsdaten in Bezug auf eine Markierung definiert sind, die der Position des mobilen Radars zu diesem Zeitpunkt zugeordnet ist, das während einer gesamten Iteration fest ist, und wobei die Zielzustandsparameter (101) eine Orientierungsmatrix, einen Krümmungsparameter, der die Krümmung der Flugbahn des Ziels definiert, einen Torsionsparameter, den Normwert eines Geschwindigkeitsvektors, der die Geschwindigkeit des Ziels darstellt, und Positionsdaten des Ziels umfasst, die durch kartesische Koordinaten definiert sind, wobei das Radar **dadurch gekennzeichnet ist, dass** die Zustandsschätzungsvorrichtung konfiguriert ist, um bei jeder Iteration Folgendes auszuführen:

- eine Markierungstransformationsfunktion, die in der Lage ist, eine Transformationsoperation auf die Markierung anzuwenden, wodurch eine transformierte Markierung bereitgestellt wird, wobei die transformierte Markierung der Position des mobilen Radars zum Zeitpunkt der aktuellen Iteration zugeordnet ist,
- eine Aktualisierungsfunktion, die in der Lage ist, die in der vorherigen Iteration ermittelten Zustandsdaten in der transformierte Markierung zu aktualisieren,
- einen erweiterten invarianten Kalman-Filter,

wobei der erweiterte invariante Kalman-Filter umfasst:

- eine Vorhersagefunktion, die in der Lage ist, einen a priori geschätzten Zustand des Ziels zu bestimmen, der in

**EP 4 042 197 B1**

der transformierten Markierung definiert ist, ausgehend von den Daten, die die in der vorherigen Iteration ermittelten Zustandsdaten umfassen, die in der transformierte Markierung aktualisiert wurden,
- eine Korrekturfunktion, die in der Lage ist, einen a posteriori-Zustand des Ziels zu bestimmen, der in der transformierten Markierung definiert ist, ausgehend von den Daten, die die Daten des a priori geschätzten Zustands des Ziels und die Daten aus mindestens einem der Verfolgungssignale umfassen.

**Claims**

1. Method for estimating the status of a target (101) implemented in a mobile radar (102) moving in a given space, said radar receiving a plurality of estimation signals relating to said target (101), the method comprising one or more iterations, each of said iterations being associated with a given moment and comprising a step of applying an invariant extended Kalman filter, each iteration providing an estimation of the status of the target represented by status data comprising a set of status parameters and an associated covariance matrix, said status data being defined in relation to a reference point associated with the position of said mobile radar at said moment, fixed throughout an iteration, and the target status parameters (101) comprising an orientation matrix, a curvature parameter defining the curvature of the trajectory of the target, a torsion parameter, the norm of a speed vector representing the speed of said target, and position data of the target defined by Cartesian coordinates, the method being **characterised in that** each current iteration comprising the steps consisting in:

   - Applying a transformation operation to the reference point (401), which provides a transformed reference point, the transformed reference point being associated with the position of the mobile radar at the moment associated with the current iteration,
   - Updating (402) in the transformed reference point, the determined status data at the preceding iteration,
   - Applying the invariant extended Kalman filter (403, 404),

   said step of applying the invariant extended Kalman filter comprising the steps consisting in:

   - Determining an a priori estimated status (403) of the target defined in the transformed reference point from the data comprising the determined status data at the preceding iteration updated in the transformed reference point,
   - Determining an a posteriori status of the target (404) defined in the transformed reference point from the data comprising the data of the a priori estimated status and the data coming from at least one of the estimation signals.

2. Method for estimating the status of a target according to claim 1, **characterised in that** the radar operates in active mode and in passive mode, and **in that** said estimation signals comprise one or more passive estimation signals, sequentially emitted by said manoeuvring target (101) and one or more active estimation signals backscattered by said manoeuvring target in response to at least one active signal emitted by the mobile radar (102).

3. Method for estimating the status of a target according to claim 2, **characterised in that** the number of active estimation signals is less than the number of passive estimation signals.

4. Method for estimating the status of a target according to claim 3, **characterised in that** the a posteriori status of said target is further determined from the noise covariance matrix associated with each monitoring signal, the noise covariance matrix associated with an active estimation signal being different from the noise covariance matrix associated with a passive estimation signal.

5. Method for estimating the status of a target according to any one of preceding claims 2 to 4, **characterised in that** said torsion parameter is maintained substantially equal to zero.

6. Method for estimating the status of a target according to claim 5, **characterised in that** the status parameters comprise an angle defining the course of the target, a Cartesian position of the two-dimensional target, a curvature parameter defining the curvature of the trajectory of the target and a norm of a speed vector representing the movement speed of the maneuvering target (101) in said movement plane.

7. Method for estimating the status of a target according to any one of the preceding claims, **characterised in that** the status parameters of the target further comprise the norm of the speed vector representing the speed of the manoeuvring target (101) defined in relation to a measuring reference point, fixed and invariant over time.

## EP 4 042 197 B1

8. Method for estimating the status of a target according to any one of claims 2 to 7, **characterised in that** one single active estimation signal from among said estimation signals is used to estimate the status of the maneuvering target (101).

9. Method for estimating the status of a target according to any one of the preceding claims, **characterised in that** it further comprises the determination of the elevation angle and of the azimuth angle defining the direction in which the maneuvering target (101) is located in relation to said mobile radar (102) from a passive estimation signal received by the mobile radar (102).

10. Method for estimating the status of a target according to any one of the preceding claims, **characterised in that** it further comprises the determination of at least one of the following parameters from an active estimation signal received by the mobile radar (102):

    - the elevation angle and the azimuth angle defining the direction in which the maneuvering target (101) is located in relation to said mobile radar (102),
    - the relative distance separating the mobile radar (102) from the target (101),
    - the radial speed of the target (101) in relation to said mobile radar (102).

11. Method for estimating the status of a target according to any one of the preceding claims, **characterised in that** the mobile radar (102) is airborne or spatial.

12. Method for estimating the status of a target according to any one of the preceding claims, **characterised in that** the status data received by the first iteration are initialisation status data.

13. Mobile radar (102) comprising a device for estimating the status of a target (101) moving in a given space, said radar receiving a plurality of estimation signals relating to said target (101), executing one or more iterations, each of said iterations associated with a given moment comprising an application of an invariant extended Kalman filter and providing an estimation of the status of the target represented by status data comprising a set of status parameters and an associated covariance matrix, said status data being defined in relation to a reference point associated with the position of said mobile radar at said moment, fixed throughout an iteration, and the target status parameters (101) comprising an orientation matrix, a curvature parameter defining the curvature of the trajectory of the target, a torsion parameter, the norm of a speed vector representing the speed of said target, and position data of the target defined by Cartesian coordinates, the radar being **characterised in that** said status estimation device is configured to execute, at each iteration:

    - A reference point transformation function, capable of applying a transformation operation to the reference point, which provides a transformed reference point, the transformed reference point being associated with the position of the mobile radar at the moment associated with the current iteration,
    - An updating function, capable of updating in the transformed reference point, the determined status data at the preceding iteration,
    - An invariant extended Kalman filter,

    said invariant extended Kalman filter comprising:

    - A prediction function capable of determining an a priori estimated status of the target defined in the transformed reference point from the data comprising the determined status data at the preceding iteration updated in the transformed reference point,
    - A correction function, capable of determining an a posteriori status of the target defined in the transformed reference point from the data comprising the data of the a priori estimated status and the data coming from at least one of the monitoring signals.

[Fig. 1]

[Fig. 2]

[Fig. 3]

[Fig. 4]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MARION PILTÉ** ; **SILVÈRE BONNABEL** ; **FRÉDÉRIC BARBARESCO**. Invariant Extended Kalman Filter for Target Tracking. *URSI France*, 2018